# EUROPEAN PATENT APPLICATION

(11) **EP 4 274 390 A1**
(43) Date of publication of application: **08.11.2023**
(21) Application number: 23169440.7
(22) Date of filing: 24.04.2023
(51) Int. Cl.: H05K 1/03, D03D 1/00, D06M 11/83, H05K 3/12, H05K 3/18

(54) **CONDUCTIVE CIRCUIT FABRIC**

(30) Priority: 25.04.2022 JP 2022071767; 03.03.2023 JP 2023033081
(71) Applicant: Seiren Co., Ltd., Fukui-shi Fukui 918-8560 (JP)
(72) Inventor: Takeuchi, Tomoya, Fukui, 918-8560 (JP); Inagaki, Shunsuke, Fukui, 918-8560 (JP)
(74) Representative: Hoffmann Eitle

(57) **Abstract**

The present invention provides a conductive circuit fabric comprising a fabric made of a fiber material and a conductive circuit made of a conductive pattern containing metal which is formed on the surface of said fabric , wherein the metal amount M₀ (µg/mm²) in the outline region of the conductive pattern is smaller than the metal amount M_{I} (µg/mm²) in the inner region of the conductive pattern, as well as a method for producing the same, which involves a printing process.

## Description

### Technical Field

The present invention relates to a conductive circuit fabric. In particular, the present invention relates to a conductive circuit fabric wherein a conductive circuit having a sharp outline free from bleeding is formed thereon.

### Background Art

As a flexible circuit board, we have used so-called FPC (Flexible Printed Circuits) wherein a conductive material such as a copper foil is laminated on a film such as a polyimide resin film in the past. Since the FPC is thin and flexible, it is used as a wire at a bending part or a movable part. However, flexibility and bending durability have not attained a satisfactory level usable for a wearable device or the like.

As a more flexible material for a conductive circuit having high bending durability, it has been studied to use a conductive circuit fabric wherein a conductive circuit is formed on a fabric made of fibers. However, forming a conductive circuit on a fabric by laminating a metal foil can not solve a problem of peeling or breaking due to deformation. It has also been studied to form a conductive circuit by a printing means using ink containing a conductive material, or to form a conductive circuit on a fabric by printing a pattern for a conductive circuit using ink containing an electroless plating catalyst and then performing electroless plating.

In the case of using a printing means using ink, there is a major problem that accuracy in a circuit shape deteriorates due to bleeding of the ink. When the circuit shape is blurred, it becomes difficult to form a fine circuit pattern. This is because failures such as a short-circuit may occur due to bleeding.

Therefore, Patent Document 1 discloses a method for producing a conductive fabric wherein, after masking the area on the insulating fabric where the electrode or wiring is not formed, the fabric is coated with a paint containing a conductive material, and then the masking is removed to form the electrode or wiring on the fabric. However, it is difficult to eliminate bleeding by the masking method, and the number of manufacturing steps increases.

A method of preventing ink bleeding by forming a printing base layer of a resin on the fabric is also conceivable, but this method reduces the flexibility of the fabric.

The present applicant discloses in Patent Document 2 a method for producing a conductive fabric wherein a dispersion of metal nanoparticles having an average particle size of 200 nm or less is applied to a fabric having a specific surface roughness, and then the fabric is baked to form a metal conductive pattern.

In this document, a method is proposed in which a cationic surfactant or the like is applied to the fabric in advance in order to prevent bleeding at the time of applying the dispersion of metal nanoparticles. However, the use of cationic surfactants has the problem of increasing the burden of wastewater treatment.

### Prior Art Documents

### [Patent Document]

Patent Document 1: Jpn. Pat. Laid-Open Publication No.2014-151018
Patent Document 2: Jpn. Pat. Laid-Open Publication No.2019-26946

### Disclosure of the Invention

### Problems to be Solved by the Invention

An object of the present invention is to provide a conductive circuit fabric that can be manufactured by a simpler method and that does not cause bleeding in the circuit shape.

### Means for Solving the Problems

In view of the above problems, the present inventors have made intensive research and found that it is possible to form a circuit without bleeding by avoiding a structure that causes bleeding in which the amount of metal gradually decreases in the direction of the outline from the center of the conductive pattern forming the circuit to adopt a new metal concentration structure in which the amount of metal decreases stepwise in the direction of the outline from the center, or the amount of metal has a stepwise gradient, and have completed the present invention.

The conductive circuit fabric of the present invention is characterized in that a conductive circuit made of a conductive pattern containing metal is formed on the surface of a fabric made of a fiber material, wherein the metal amount M_{O} (µg/mm²) in the outline region of the conductive pattern is smaller than the metal amount M_{I} (µg/mm²) in the inner region of the conductive pattern.

It is preferable that the ratio (M_{O}/M_{I}) of the metal amount M_{O} in the outline region and the metal amount M_{I} in the inner region is 0.3 to 0.9.

An intermediate region having a metal amount M_{M} satisfying M_{O}<M_{M}<M_{I} may be provided between the outline region and the inner region.

It is preferable that said conductive pattern includes a linear pattern having a width of 100 um or more, which has a line shape having a longitudinal direction and a width direction and has outline regions at both ends in the width direction and an inner region sandwiched between the outline regions.

As a method for producing the conductive circuit fabric, it is preferable to employ a method comprising a printing process of printing a conductive pattern using a printing method.

It is preferable that said printing process comprises a process of printing a conductive pattern by an inkjet method using an inkjet printing device.

It is preferable that said printing process comprises a printing process using an ink composition containing metal particles having an average particle size of 1 to 200 nm.

It is preferable that the method for producing a conductive circuit fabric further comprises a plating treatment process that performs a metal plating treatment after said printing process.

### Effect of the Invention

The present invention provides a conductive circuit fabric with a conductive pattern capable of exhibiting high definition free from bleeding, without impairing flexibility of the fabric.

### Brief Description of Drawings

[Fig.1]

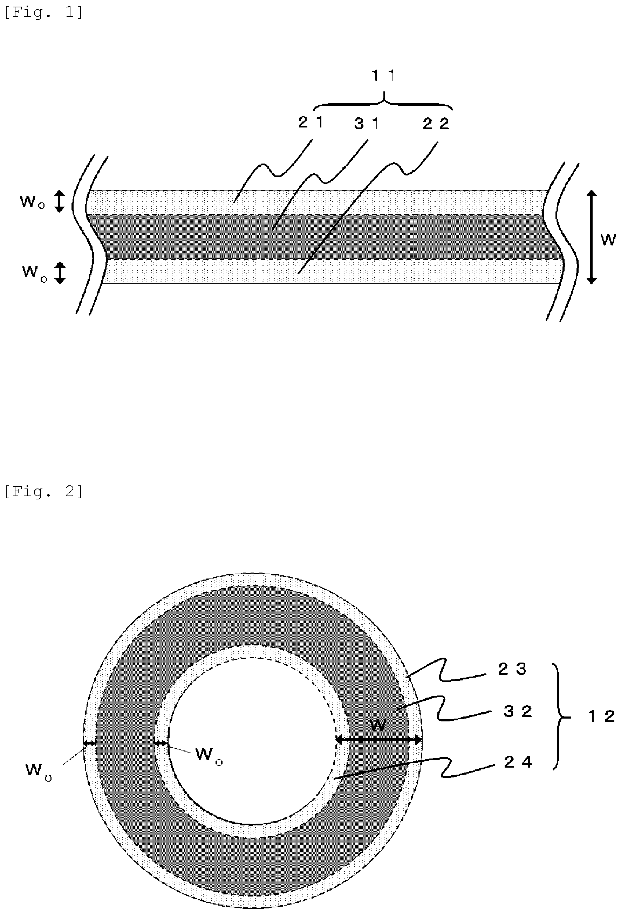

   Figure 1 is a schematic view showing one embodiment of a conductive pattern of the conductive circuit fabric according to the present invention.
[Fig.2]
   Figure 2 is a schematic view showing another embodiment of a conductive pattern of the conductive circuit fabric according to the present invention.
[Fig.3]

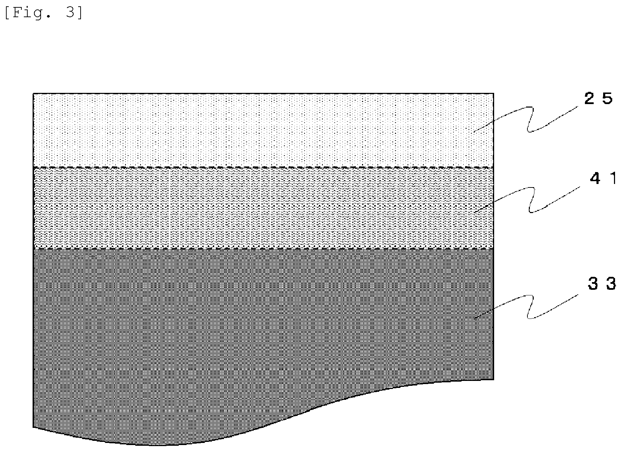

   Figure 3 is a schematic view showing yet another embodiment of a conductive pattern of the conductive circuit fabric according to the present invention.

### Modes for Carrying Out the Invention

According to the conductive circuit fabric of the present invention, a fabric made of a fiber material is used as a base material. In particular, examples of the fiber materials include natural fibers such as cotton, linen, wool and silk, regenerated fibers such as rayon and cupra, semi-synthetic fibers such as acetate and triacetate, synthetic fibers such as polyamide (nylon 6, nylon 66, etc.), polyester (polyethylene terephthalate, polytrimethylene terephthalate, etc.), polyurethane, polyacrylic acid, aramid and polyparaphenylene benzobisoxazole, inorganic fibers such as glass fibers, basalt fibers and carbon fibers, though not limited to these examples.

As the fiber material, synthetic fibers are preferable from the viewpoint of versatility, flexibility and strength. Among them, polyamide and polyester are particularly preferred.

Although the thickness of the fabric is not particularly limited, it is preferably 10 to 5000 µm, more preferably 50 to 1000 µm.

The fabric made of the above-mentioned fiber materials is not particularly limited, and may be a woven fabric, a knitted fabric, a non-woven fabric, or the like. Yarns constituting the fabric are also not particularly limited. The fabric may be dyed or be subjected to various finishing processes according to the needs.

According to the conductive circuit fabric of the present invention, a conductive pattern is formed on the surface of the fabric. The surface can be the front side or the back side of the fabric, or both. The conductive pattern can form a conductive circuit by itself or a plurality of conductive patterns can be connected to form a conductive circuit.

The conductive pattern contains metal. The conductive pattern may be formed not only on the surface of the fabric but also in the fabric so as to permeate into the thickness direction thereof. The conductive pattern can also be permeated in the fabric in a state of penetrating from the front surface to the back surface of the fabric.

The shape of the conductive pattern is not particularly limited. Examples of the shape include a line shape (a line shape, a belt shape, a ribbon shape, etc.) having a longitudinal direction and a lateral direction (width direction), a ring shape (a doughnut shape, etc.) wherein the line is bended in a circular shape with both ends closed to form an opening in or near the center, and a circular shape having no opening with the center closed.

The conductive pattern of the present invention may be a pattern having various shapes such as the above-mentioned line shape and ring shape, and may be a single pattern or a combination of a plurality of patterns thereof.

An example of a linear pattern is shown in FIG. 1. The linear conductive pattern shown in FIG. 1 has a width W in a direction substantially perpendicular to the longitudinal direction (a lateral direction or a width direction) . The line may extend straight in the longitudinal direction or may be curved as appropriate. The width of the lines may or may not be uniform. Preferably, it is substantially uniform.

An example of a ring-shaped pattern is shown in FIG. 2. The ring is not limited to a circular shape, and any shape is acceptable as long as both ends in the longitudinal direction of the line are closed.

The shape of the conductive pattern in the present invention is preferably a line shape or a ring shape, and more preferably a line shape. Though the width of the line-shaped or ring-shaped pattern is not particularly limited as long as it is a width that can be used in a normal conductive pattern in the relevant technical field, it is preferably 100 um or more, more preferably 200 um or more as an appropriate width for exhibiting the specific effects of the present invention. The upper limit of the line width is not particularly limited as long as it is the upper limit of the line width that can be used in a normal conductive pattern in the relevant technical field.

According to the present invention, the conductive pattern has at least an outline region and an inner region therein. In the present invention, the "region" in the outline region and the inner region means "the region in which the metal concentration is substantially constant". For example, the outline region (or the contour region) is an area along the outline (the contour) of the conductive pattern having a substantially constant width toward the center of the pattern, in which the metal concentration (the amount of metal per unit area) is substantially constant. The inner region is an area having a substantially constant width from the center of the conductive pattern toward the outline direction having a substantially constant metal concentration in the area.

Although there is no particular limitation as long as the "substantially constant metal concentration" is within a range that is considered to be a certain level in socially accepted terms, the rate of change (or allowance) is, for example, preferably within ±8%, more preferably within ±4%.

Although the "substantially constant width" is not particularly limited as long as it is within a range of width that is considered to be a certain degree in socially accepted terms, the rate of change (or allowance) is, for example, preferably within ±15%, more preferably within ±8%. However, the rate of change of the width of the region may be appropriately adjusted according to the shape and application of the conductive pattern.

For example, when the conductive pattern is line-shaped, the outline region is an area formed along the outline in the longitudinal direction of the line-shaped conductive pattern having a substantially constant width toward the center of the pattern in the width direction. In the case of a line-shaped conductive pattern, outline regions are generally formed, along the longitudinal direction, on both sides of the line in the width direction.

The inner region is an area formed along the longitudinal direction of the line-shaped conductive pattern so as to have a substantially constant width toward the outline direction from the center in the width direction of said region which is the center in the width direction of the line-shaped conductive pattern.

According to the conductive pattern of the present invention, it is essential that the metal amount M_{O} in the outline region is smaller than the metal amount M_{I} in the inner region. When forming the conductive pattern, by controlling the metal amount M_{O} and the metal amount M_{I} in such a manner, a conductive pattern without bleeding can be formed. The "metal amount" here means the amount of metal per unit area (or the metal concentration).

An embodiment of the outline region and the inner region in the line-shaped conductive pattern will be described with reference to FIG. 1.

FIG.1 shows an embodiment of a long line-shaped conductive pattern 11 used for wiring on a conductive circuit or the like. In this embodiment, the line-shaped conductive pattern 11 has a uniform width W. Since the length can be appropriately designed, the ends in the length direction are not shown in this figure.

In this embodiment, the line-shaped conductive pattern 11 is divided into three regions in the width direction. These are the outline region 21, the inner region 31 and the other outline region 22. The outline region 21 corresponds to the upper outer edge of the conductive pattern 11 in the figure. Since the ends in the length direction are omitted in this embodiment of FIG. 1, the conductive pattern 11 shown in FIG.1 has two outline edges, namely, an upper side and a lower side, which are consisting of outline regions defined as a outline region 21 and a outline region 22, respectively.

Although, in this embodiment of FIG. 1, the outline regions 21 and 22 are depicted as having the same width W_{O} for convenience, outline regions 21 and 22 may have different widths. In FIG. 1, the area sandwiched between the two outline regions 21 and 22 is defined as the inner region 31. In the embodiment of FIG. 1, the width of the inner region 31 is (W-2Wo). If the outline regions 21 and 22 have different widths Wo1 and Wo2 respectively, the width of the inner region 31 will be W-(Wo1+Wo2).

Although the line width (W in FIG. 1) is not particularly limited in the case of a line-shaped conductive pattern, as described above, it is preferably 100 um or more, more preferably 200 um or more, as an appropriate width capable of exhibiting the specific effects of the present invention. The width of the outline region on one side of the line (21 or 22 in FIG. 1) is preferably 10 pm or more, more preferably 30 pm or more. The width of the inner region (31 in FIG. 1) is preferably 30 pm or more, more preferably 50 um or more.

The width range occupied by the outline regions in the conductive pattern is not particularly limited. In the case of a line-shaped conductive pattern as shown in FIG. 1, the width of the outline region on at least one side (the width Wo of the outline region 21 in FIG. 1, for example) can be set to be 5 to 30% to the line width (width W in FIG. 1) . If the ratio of the width Wo to the width W is within this range, it is possible to form a highly precise conductive pattern without impairing the conductivity of the conductive pattern.

The same applies to the outline region 22, and it may have the same width as the outline region 21 or may have a different width. In the case that they have a different width, at least one of the different widths Wo1 and Wo2 of the outline regions 21 and 22 respectively can be set to be 5 to 30% to the width W. More preferably, both the widths Wo1 and Wo2 are set to be 5 to 30% to the width W, respectively.

In FIG. 1, it is essential that the metal amount M_{O} of the outline region 21 (or 22) is smaller than the metal amount M_{I} of the inner region 31. The metal amounts M_{O} and M_{I} are defined as the amount of metal per unit area (µg/mm²). The term "area" here means the area of the conductive circuit fabric when seen in plan view without considering the thickness, voids, and surface irregularities of the fabric. The method for measuring the metal amounts M_{O} and M_{I} will be described later. The amount of metal in the outline region 21 and the outline region 22 may be the same or different.

In a preferred embodiment, the metal amount M_{O} in the outline region (21 or 22 in the embodiment of FIG. 1) is preferably 1.0 to 90.0 µg/mm², more preferably 3.0 to 30.0 µg/mm². The metal amount M_{I} in the inner region (31 in the embodiment of FIG. 1) is preferably 3.0 to 100.0 µg/mm², more preferably 5.0 to 50.0 µg/mm². Also, the ratio (M_{O}/M_{I}) of the metal amount M_{O} to the metal amount M_{I} is preferably 0.3 to 0.9, more preferably 0.4 to 0.7. When the amount of metal satisfies these conditions, a conductive pattern with high definition and excellent conductivity can be obtained.

The metal amount in each region (the outline region, the inner region) of the conductive pattern can be measured by the following method:
A region to be measured in the conductive pattern is cut out together with the fabric as a base material to form a sample, and the area thereof is measured. As described above, the term "area" here means the area seen in plan view without considering the thickness, voids, and surface irregularities of the fabric.

Next, the cut sample is immersed in nitric acid diluted to a concentration of 50 mass% to completely dissolve the metal layer. The aqueous solution in which the metal is dissolved thus obtained is diluted to a predetermined concentration to measure the metal concentration in the aqueous solution by atomic absorption spectrometry. The amount of metal per unit area (µg/mm²) is calculated from the area of the cut sample and the metal concentration obtained by atomic absorption spectrometry.

FIG. 2 shows an embodiment of a ring-shaped conductive pattern. The ring-shaped conductive pattern 12 in the embodiment of FIG. 2 has a width W. A ring-shaped outline region 23 with a width W_{O} is defined on the outer outline edge of the conductive pattern 12. Another ring-shaped outline region 24 having a width W_{O} is also defined on the inner outline edge of the conductive pattern 12. A region sandwiched between the two outline regions 23 and 24 is an inner region 32. The range of the width W_{O} of the outline regions 23 and 24 with respect to the width W of the conductive pattern is the same as in the embodiment of FIG. 1. The relationship between the metal amounts M_{O} in the outline regions 23 and 24 and the metal amount M_{I} in the inner region 32 is also the same as those described in FIG. 1.

According to the conductive pattern of the conductive circuit fabric of the present invention, as described above, at least an outline region and an inner region having a substantially constant amount of metal in each region are provided, and the metal amount in the outline region is set to be less than the metal amount in the inner region.

In the case of a line-shaped conductive pattern, for example, the metal amount is reduced from the center in the width direction toward the outline direction, and by changing the way of reduction in a stepwise manner and by providing outline regions with a constant metal amount smaller than that of the inner region along the outline of the pattern, a conductive pattern having a new metal concentration structure can be obtained.

A concentration structure in which the amount of metal gradually decreases from the center of the pattern in the direction of the outline, which might cause bleeding, is avoided, and a new metal concentration structure in which the amount of metal decreases stepwise from the center to the direction of the outline is adopted.

By employing such a new metal concentration structure different from the conventional one, it is possible to form a conductive pattern having a sharp outline without blurring.

According to the conductive circuit fabric of the present invention, an intermediate region can be provided between the outline region and the inner region.

Although the width W_{M} of the intermediate region is not particularly limited, it is preferably 10 um or more, more preferably 30 um or more. It is preferable that the metal amount M_{M} in the intermediate region, the metal amount M_{O} in the outline region and the metal amount M_{I} in the inner region satisfy the relationship M_{O}<M_{M}<M_{I}.

As long as the relationship M_{O}<M_{M}<M_{I} is satisfied, the metal amount of the intermediate region can be formed with gradient so that the metal amount is gradually reduced from the portion in contact with the inner region to the portion in contact with the outline region.

In addition, a plurality of intermediate regions can be provided between the outline region and the inner region, and the metal amounts of the plurality of intermediate regions can be arranged so that the metal amounts M_{M} decreases stepwise from the portion in contact with the inner region to the portion in contact with the outline region.

FIG. 3 will be used to describe an embodiment in which an intermediate region is provided between the outline region and the inner region. FIG. 3 shows an enlarged view of an arbitrary conductive pattern in the conductive circuit fabric of the present invention in the vicinity of its outer edge. As shown in FIG. 3, an intermediate region 41 may be provided between the outline region 25 and the inner region 33.

The metal amount M_{M} in the intermediate region is preferably 1.0 to 95.0 µg/mm², more preferably 4.0 to 40.0 µg/mm². The ratio (M_{O}/M_{M}) of the metal amount M_{O} to the metal amount M_{M} is preferably 0.3 to 0.9, more preferably 0.4 to 0.7. The ratio (M_{M}/M_{I}) of the metal amount M_{M} to the metal amount M_{I} is preferably 0.3 to 0.9, more preferably 0.4 to 0.7. When the amount of metal satisfies these conditions, a conductive pattern with high definition and excellent conductivity can be obtained.

The metal contained in the conductive pattern can be one or more selected from the group consisting of copper, silver, gold, nickel, iron, tin, aluminum, platinum, palladium, rhodium, ruthenium, iridium, osmium, indium, rubidium, and cobalt. It can be a mixture or alloy consisting thereof. Among them, copper is preferable because it has high conductivity and is excellent in terms of cost.

The form of the metal contained in the conductive pattern is not particularly limited. In order to form a finer conductive pattern, the metal preferably contains metal particles having an average particle size of 1 to 200 nm. A plating process may be performed using the metal particles as nuclei to deposit the same or different metals. According to this method, the outer edge portion of the conductive pattern can be formed sharply while increasing the amount of metal to improve conductivity.

The average particle size of the metal particles is the primary particle size not considering aggregation, and is measured using any method known in the present technical field, such as a transmission electron microscope (TEM), for 100 or more particles. It can be expressed by the arithmetic mean value of the sphere-equivalent particle diameter (diameter when each particle is converted into a sphere of the same volume) . In particular, the "average particle size of metal particles" in this specification means the arithmetic mean value of the sphere-equivalent particle size of 100 metal particles actually measured by a transmission electron microscope.

The conductive pattern is not particularly limited to the shape used in the above description, and may be of any shape. A free conductive circuit can be formed by using a single conductive pattern or by combining a plurality of conductive patterns. Since the outer edges of the conductive patterns do not bleed and have a sharp shape, the distance between the adjacent conductive patterns can be reduced. As a result, a high-definition and complicated conductive circuit can be produced in a compact manner at a high density.

The conductive circuit fabric comprising a conductive pattern containing a metal of the present invention is preferably produced by forming a conductive pattern on a fabric using an ink containing a conductive material so as to have the metal concentration structure as described above.

A printing method is preferably employed to form the conductive pattern. Examples of printing methods include screen printing, gravure printing, inkjet printing, xerography, stamping, flexographic printing, offset printing, painting, airbrushing, and the like, and ink compositions containing metals are used in all of these methods. Among these methods, a printing method using an inkjet system is particularly preferably employed.

In the case of a printing method using an inkjet system, for example, a line-type printing device having a plurality of nozzles such as a nozzle for the inner region and a nozzle for the outline region in which the amount and density of the ink applied can be varied for each nozzle can be used to form a conductive pattern of the present invention. Or a scanning printing method in which printing is performed while adjusting the amount of metal using a single nozzle that can be moved in the vertical and horizontal directions may also be used, but is not limited to these.

In the case of screen printing, the conductive pattern of the present invention can be formed by preparing two plates, for example, a outline region pattern and an inner region pattern having a higher aperture ratio than the outline region pattern, and performing printing twice, but not limited to these.

The ink composition is preferably an ink composition containing metal particles. In particular, it preferably contains metal particles having an average particle size of 1 to 200 nm. When an ink composition containing metal particles having such an average particle size is applied to the surface of a fabric, metal particles enter into not only gaps in the fabric structure, but also gaps between the threads constituting the fabric, that is, between single fibers As a result, the uniformity of the conductive pattern thus formed is improved, and the metal is less likely to come off.

The ink composition is a dispersion liquid of metal particles, which means a solution in which metal particles are appropriately dispersed in a solvent. Since the metal particles in the solvent tend to aggregate, a dispersing agent is added to coat the surfaces of the metal particles, thereby suppressing aggregation and stabilizing the dispersion of the metal particles.

Although the solvent to be used is not particularly limited, examples of the solvents include water, alcohol solvents (monoalcohol solvents, diol solvents, polyhydric alcohol solvents, etc.), hydrocarbon solvents, ketone solvents, ester solvents, ether solvents, glyme solvents, halogen-based solvents, and the like. These solvents may be used alone or in combination of two or more.

As the dispersing agent, any known dispersant may be appropriately selected and used. Examples thereof include amine compounds and thiol compounds, but not limited to these.

As the amine compound, an aliphatic amine compound is preferable, an aliphatic amine compound having an alkyl moiety with 4 to 10 carbon atoms is more preferable.

Examples of aliphatic amine compounds include alkylamines such as octylamine, dodecylamine and hexadecylamine, and alkenylamines such as oleylamine.

As the thiol compound, an aliphatic thiol compound is preferable. Examples of aliphatic thiol compounds include alkylthiols such as hexanethiol, pentanedithiol, decanethiol, and dodecanethiol.

Dispersants may be used alone or in combination of two or more. By using a dispersant with a small number of carbon atoms, it can be desorbed or decomposed under easy conditions.

The mixing ratio of the metal particles in the ink composition is preferably 0.1 to 70 mass%, more preferably 1 to 60 mass%, and still more preferably 10 to 50 mass% with respect to the total mass of the ink composition.

In addition to metal particles, solvents and dispersants, the ink composition may contain known additives for the purpose of adjusting printability. Examples of additives include thickeners, stabilizers, and the like.

A method for forming a conductive pattern by applying the ink composition containing metal particles to the surface of a fabric as a base material using a piezo-type inkjet printer will be described in detail as one embodiment.

In the case of an inkjet printer having an inkjet head with a plurality of nozzles, for example, ink is supplied from an ink tank through an ink supply path to the inkjet head in which piezoelectric elements are arranged for each nozzle.

Next, image data corresponding to the conductive pattern to be formed is created to define an outline region and an inner region. When forming a conductive pattern shown in FIG. 1 as an embodiment, the image data holds the width W of the line-shaped conductive pattern and the width W_{O} of the two outline regions. The image data also holds a target amount of metal to be applied for the outline region and the inner region.

Based on the image data, each region of the conductive pattern is associated with each nozzle of the ink jet head, and an electric signal is sent to the piezoelectric element provided for each nozzle. Ink is ejected as nozzle droplets by driving a piezoelectric element that receives the electrical signal.

Each nozzle of the plurality of nozzles can have a different ejection amount (coating amount) by adjusting the ink ejection pressure or the like. Using this function, it is possible to adjust the ink discharge amount so as to achieve the target amount of metal to be applied set based on the image data for each nozzle. Alternatively, inks with different compositions (or different metal concentrations) can be used for each nozzle. This allows the amount of metal in each region of the printed conductive pattern to have a desired stepwise gradient.

When using an inkjet printing device using a single nozzle (for example, a scanning printing device), by performing ejection with a controlled ejection amount (or controlled droplet size) while scanning the single nozzle vertically and horizontally, the metal amount gradient of the inner region and the outline region can be controlled.

In the case of providing an intermediate region, a line-type inkjet printing device with multiple nozzles or a scanning inkjet printing device with a single nozzle can be used. The amount of ink ejected and the like can be set so that the amount of metal per unit area decreases stepwise from the inner region toward the outline region.

The target amount of metal to be applied to the outline region and the inner region can be appropriately determined based on the state of the fabric as the base material, the target resistance value of the resulting conductive pattern, and the like. When using the ink jet printing device, since the drive of the piezoelectric element can be controlled by the electric signal, the ejection amount of ink and the number of droplets to be ejected can be varied. Further, by combining control of scanning of the ink-jet head or the fabric to be printed and control of driving of the piezoelectric element, it is possible to provide a difference in the amount of metal to be applied to the outline region and the inner region.

The conductive pattern in the conductive circuit fabric of the present invention may be further subjected to metal plating treatment after being formed by applying metal particles by the above-described inkjet printing. According to this treatment, the amount of metal can be increased both in the outline region and the inner region, and a conductive circuit fabric having a higher conductivity can be manufactured. Moreover, the fixing strength of the conductive pattern to the fabric is increased, and the conductive pattern can be made less likely to come off. In this case, the metal amount in each region is the sum of the amount of metal particles applied by inkjet printing and the amount of metal deposited by metal plating.

The metal plating treatment includes electroplating treatment and electroless plating treatment, and any of them may be used. Preferably, electroless plating treatment is used. The metal used for the plating treatment may be the same as or different from the metal particles contained in the ink composition. Preferably, the metal particles contained in the ink composition and the metal used for the plating treatment are the same metal type. More preferably, copper is used for both the metal particles contained in the ink composition and the metal for plating.

A conventionally known technique can be adopted for the metal plating treatment, and there are no particular restrictions on the chemicals, equipment, conditions, and the like to be used. Optimal conditions can be selected and carried out depending on the type of metal to be deposited, the amount of metal, and the like.

For example, when electroless plating is performed, a conductive pattern is printed on a fabric with an ink composition, and then the solvent of the ink composition is removed by heating, drying, or the like. Next, the fabric is immersed in an electroless plating treatment solution to perform electroless plating.

The conductive pattern formed on the conductive circuit fabric of the present invention has excellent conductivity with a surface resistance of preferably less than 10 MΩ/□, more preferably less than 10 KΩ/□.

The conductive circuit fabric of the present invention may further form a cover coat (protective film) on the formed conductive pattern depending on the final purpose of use. The cover coat may be formed, for example, so as to cover at least the metal conductive pattern, or may be formed so as to cover the one side of the fabric entirely. The cover coat is mainly formed for the purpose of insulating, waterproofing, and/or preventing breakage of a metal conductive pattern formed on the fabric. Although the resin material used for the cover coat is not particularly limited, it is preferable to employ urethane-based resins, silicone-based resins, and the like. More specific examples include polyurethane resins and silicone resins. Further specific examples include polyether-based polyurethane and the like. Although the thickness of the cover coat is not particularly limited, it is preferably about 5 to 20 um.

### Examples

Hereinafter, the present invention will be described in more detail with reference to examples, but the present invention is not limited by the following examples, and can be modified appropriately within the scope that can conform to the gist of the above and later descriptions, all of which are included in the technical scope of the present invention.

### [Evaluation of Bleeding]

A line-shaped conductive pattern was formed on the fabric as the base material. The conductive pattern thus formed was subjected to measurement of the actual width (= an area where transmitted light was blocked) under transmitted illumination using a microscope, manufactured by KEYENCE CORPORATION.

The increased proportion of the actual width thus obtained from the width (W) set in each example was defined as the rate of increase (%), and evaluation was made as follows:
○: The rate of increase being less than 30%
×: The rate of increase being 30% or more

### [Example 1]

A polyester plain-woven fabric (warp: polyester processed yarn 33 dtex / 36f, weft: polyester processed yarn 69 dtex / 150f, weave density: warp 189/25.4 mm, weft 120/25.4 mm, thickness 90 µm) was used as a base fabric.

Trade name "IJ-02", manufactured by ISHIHARA CHEMICAL Co., Ltd., was used as an ink composition containing metal particles. The ink composition contains 35-45 mass% of copper particles with an average particle size of 70 nm, 50-60 mass% of diethylene glycol monobutyl ether, and less than 5 mass% of an activator.

A line-shaped conductive pattern similar to that shown in FIG. 1 was formed by applying the above-mentioned ink composition to the fabric using an inkjet printing device (trade name "SIT-M10" manufactured by SEIREN Co., Ltd., the number of nozzles: 3 or more).

The width W of the conductive pattern was set to 600 um and the width W_{O} of the outline region was set to 160 um.

The amount of ink applied in the outline region was set to 18 pl/dot, and the amount of ink applied in the inner region was set to 30 pl/dot. Printing was performed twice at a resolution of 300 dpi. After printing, drying was performed in an oven at 65°C for 5 minutes to volatilize the solvent.

The fabric on which the conductive pattern was printed was immersed into an electroless copper plating solution at 40°C for 20 minutes to perform electroless plating treatment, said electroless copper plating solution being comprising 8.75 g/L of copper chloride dihydrate, 20 g/L of an urethane resin "EDP-300" (trade name, manufactured by ADEKA CORPORATION), 40 mL/L of a 32 mass% sodium hydroxide aqueous solution, and 8.75 mL/L of a 37 mass% formaldehyde aqueous solution. Subsequently, the fabric was washed with water and dried in an oven at 65°C for 10 minutes.

The metal amount in each region of the conductive pattern of the conductive circuit fabric thus obtained was 37.6 µg/mm² in the outline region and 42.7 µg/mm² in the inner region, and M_{O}/M_{I}=0.9. The bleeding was evaluated as ○.

### [Example 2]

A conductive circuit fabric was obtained in the same manner as in Example 1, except that the width W of the conductive pattern was set to 1000 um, the width W_{O} of the outline region was set to 240 µm, the amount of ink applied to the outline region was set to 6 pl/dot, the amount of ink applied to the inner region was set to 24 pl/dot, and printing was performed twice at a resolution of 300 dpi.

The metal amount in each region in the conductive pattern of the conductive circuit fabric thus obtained was 11.8 µg/mm² in the outline region and 38.6 µg/mm² in the inner region, and M_{O}/M_{I}=0.3. The bleeding was evaluated as ○.

### [Example 3]

A conductive circuit fabric was obtained in the same manner as in Example 1, except that the width W of the conductive pattern was set to 5000 um, the width W_{O} of the outline region was set to 320 um, the amount of ink applied to the outline region was set to 12 pl/dot, the amount of ink applied to the inner region was set to 30 pl/dot and printing was performed twice at a resolution of 300 dpi.

The metal amount in each region in the conductive pattern of the conductive circuit fabric thus obtained was 20.4 µg/mm² in the outline region and 42.7 µg/mm² in the inner region, and M_{O}/M_{I}=0.5. The bleeding was evaluated as ○.

### [Example 4]

A conductive circuit fabric was obtained in the same manner as in Example 1, except that the width W of the conductive pattern was set to 1000 um, the width W_{O} of the outline region was set to 160 um, the amount of ink applied to the outline region was set to 12 pl/dot, the amount of ink applied to the inner region was set to 42 pl/dot, printing was performed twice at a resolution of 300 dpi, and then immersion into the electroless copper plating solution was performed for 46 minutes.

The metal amount in each region in the conductive pattern of the conductive circuit fabric thus obtained was 45.3 µg/mm² in the outline region and 66.8 µg/mm² in the inner region, and M_{O}/M_{I}=0.7. The bleeding was evaluated as O.

### [Example 5]

A conductive circuit fabric was obtained in the same manner as in Example 1, except that the width W of the conductive pattern was set to 1000 um, the width W_{O} of the outline region was set to 160 um, the amount of ink applied to the outline region was set to 12 pl/dot, the amount of ink applied to the inner region was set to 18 pl/dot, printing was performed twice at a resolution of 300 dpi, and then immersion into the electroless copper plating solution was performed for 4 minutes.

The metal amount in each region in the conductive pattern of the conductive circuit fabric thus obtained was 1.9 µg/mm² in the outline region and 4.8 µg/mm² in the inner region, and M_{O}/M_{I}=0.4. The bleeding was evaluated as ○.

### [Example 6]

A conductive circuit fabric was obtained in the same manner as in Example 1, except that the width W of the conductive pattern was set to 2000 um, the width W_{O} of the outline region was set to 160 um, the width W_{M} of the intermediate region was set to 160 um, the amount of ink applied to the outline region was set to 12 pl/dot, the amount of ink applied to the intermediate region was set to 24 pl/dot, the amount of ink applied to the inner region was set to 42 pl/dot and printing was performed twice at a resolution of 300 dpi.

The metal amount in each region in the conductive pattern of the conductive circuit fabric thus obtained was 20.4 µg/mm² in the outline region, 38.6 µg/mm² in the intermediate region and 47.6 µg/mm² in the inner region, and M_{O}/M_{I}=0.4. The bleeding was evaluated as O.

### [Comparative Example 1]

A conductive circuit fabric was obtained in the same manner as in Example 1, except that the amount of ink applied was 42 pl/dot for the entire conductive pattern with a width W (600 um) without distinguishing between the outline region and the inner region.

The metal amount in the conductive pattern of the obtained conductive circuit fabric was 49.1 µg/mm² without distinguishing between the outline region and the inner region. The bleeding was evaluated as ×, and the accuracy was insufficient.

Table 1 shows the evaluation results of the conductive circuit fabrics obtained in Examples 1 to 6 and Comparative Example 1. In contrast to Comparative Example 1, Examples 1 to 6 show that the metal amount in the outline region is smaller than that in the inner region, so that the conductive pattern can be formed with little bleeding and high accuracy. Example 6 is an example in which an intermediate region is provided between the inner region and the outer region.

**[Table 1]**

| | | Ex. 1 | Ex. 2 | Ex. 3 | Ex. 4 | Ex. 5 | Ex. 6 | Comp.Ex.1 |
|---|---|---|---|---|---|---|---|---|
| M_{O} (µg/mm²) | | 37.6 | 11.8 | 20.4 | 45.3 | 1.9 | 20.4 | 49.1 |
| M_{M} (µg/mm²) | | - | - | - | - | - | 38.6 | - |
| M_{I} (µg/mm²) | | 42.7 | 38.6 | 42.7 | 66.8 | 4.8 | 47.6 | 49.1 |
| M_{O}/M_{I} | | 0.9 | 0.3 | 0.5 | 0.7 | 0.4 | 0.4 | 1.0 |
| Bleeding | Rate of increase | 17% | 11% | 5% | 19% | 14% | 13% | 50% |
| | Evaluation | ○ | ○ | ○ | ○ | ○ | ○ | × |

### Explanation of Reference Letters

11, 12: Conductive Pattern
21, 22, 23, 24, 25: Outline Region
31, 32, 33: Inner Region
41: Intermediate Region
W: Width of conductive pattern
W_{O}: Width of outline region in the conductive pattern

## Claims

1. A conductive circuit fabric comprising a fabric made of a fiber material and a conductive circuit made of a conductive pattern containing metal which is formed on the surface of said fabric, wherein the metal amount M_{O} (µg/mm²) in the outline region of the conductive pattern is smaller than the metal amount M_{I} (µg/mm²) in the inner region of the conductive pattern.

2. The conductive circuit fabric according to claim 1, wherein the ratio (M_{O}/M_{I}) of the metal amount M_{O} in the outline region and the metal amount M_{I} in the inner region is 0.3 to 0.9.

3. The conductive circuit fabric according to claim 1 or 2, wherein an intermediate region having a metal amount M_{M} satisfying M_{O}<M_{M}<M_{I} is provided between the outline region and the inner region.

4. The conductive circuit fabric according to claim 1 or 2, wherein said conductive pattern includes a line-shaped pattern having a width of 100 um or more which has a longitudinal direction and a width direction and has outline regions at both ends in the width direction and an inner region sandwiched between the outline regions.

5. A method for producing the conductive circuit fabric according to claim 1, which comprises a printing process of printing a conductive pattern using a printing method.

6. The method for producing the conductive circuit fabric according to claim 5, wherein said printing process comprises a process of printing a conductive pattern by an inkjet method using an inkjet printing device.

7. The method for producing the conductive circuit fabric according to claim 5, wherein said printing process comprises a printing process using an ink composition containing metal particles having an average particle size of 1 to 200 nm.

8. The method for producing the conductive circuit fabric according to claim 5, which comprises a plating treatment process that performs a metal plating treatment after said printing process.
